# EUROPEAN PATENT SPECIFICATION

(11) **EP 2 362 003 B1**
(45) Date of publication and mention of the grant of the patent: **05.07.2017**
(21) Application number: 10275131.0
(22) Date of filing: 20.12.2010
(51) Int. Cl.: C23C 16/40, C23C 16/455, C23C 16/50, C23C 16/505, C23C 16/52, C23C 16/56

(54) **Method of depositing SiO2 films**
Verfahren zum Auftragen einer SiO2-Folie
Procédé pour déposer des films de SiO2

(30) Priority: 24.12.2009 GB 0922647
(43) Date of publication of application: 31.08.2011
(73) Proprietor: SPP Process Technology Systems UK Limited, Newport Gwent NP18 2TA (GB)
(72) Inventor: Giles, Katherine, Wotton-Under-Edge, Gloucestershire GL12 9LN (GB); Price, Andrew, Ebbw Vale, Gwent NP23 5UB (GB); Burgess, Stephen Robert, Ebbw Vale, Gwent NP23 5NA (GB); Archard, Daniel Thomas, Port Talbot, West Glamorgan SA12 9SS (GB)
(74) Representative: Wynne-Jones, Lainé and James LLP

(56) References cited:
- DE-A1- 19 523 442
- US-A- 6 093 637
- US-B1- 7 629 227
- JAE-KEUN KIM ET AL: "Characterization and preparation of SiO2 and SiOF films using an RF PECVD technique from TEOS/O2 and TEOS/O2/CF4 precursors; Preparation of the high quality SiO2 and SiOF films", JOURNAL OF PHYSICS D. APPLIED PHYSICS, IOP PUBLISHING, BRISTOL, GB, vol. 37, no. 17, 7 September 2004 (2004-09-07), pages 2425-2431, XP020015658, ISSN: 0022-3727, DOI: DOI:10.1088/0022-3727/37/17/013
- HERMAN J S ET AL: "A TWO-TEMPERATURE TECHNIQUE FOR PECVD DEPOSITION OF SILICON DIOXIDE", IEEE ELECTRON DEVICE LETTERS, IEEE SERVICE CENTER, NEW YORK, NY, US, vol. 12, no. 5, 1 May 1991 (1991-05-01), page 236/237, XP000200639, ISSN: 0741-3106, DOI: DOI:10.1109/55.79568
- SHASHANK C DESHMUKH ET AL: "LOW-TEMPERATURE PLASMA ENHANCED CHEMICAL VAPOR DEPOSITION OF SIO2", APPLIED PHYSICS LETTERS, AIP, AMERICAN INSTITUTE OF PHYSICS, MELVILLE, NY, US, vol. 65, no. 25, 19 December 1994 (1994-12-19), pages 3185-3187, XP000485999, ISSN: 0003-6951, DOI: DOI:10.1063/1.112475
- RICCARDO D'AGOSTINO, FRANCESCO FRACASSI, FABIO PALUMBO, EMMA ANGELINI, SABRINA GRASSINI, FRANCESCO ROSALBINO: "Protection of Silver-Based Alloys from Tranishing by Means of Plasma-Enhanced Chemical Vapor Deposition", PLASMA PROCESS. POLYM., vol. 2, 1 January 2005 (2005-01-01), pages 91-96, XP002630828,

## Description

This invention relates to a method of depositing SiO₂ films and in particular to depositing such films below 250°C using plasma enhanced chemical vapour deposition (PECVD) according to claim 1. Through silicon vias (TSVs), which can for example be etched vias or trenches in silicon, require a dielectric liner prior to metallic layer deposition. It is highly desirable that such films are good conformal films because of their minimum thickness the dielectric properties have to be good enough to avoid current leakage in normal use. There also has to be limited, if any, moisture absorption following the depositions step, particularly as quite commonly the next step will follow a vacuum break. It is also desirable that they can be deposited at low temperatures, preferably below even 200°C whilst being conformal and non absorbent.

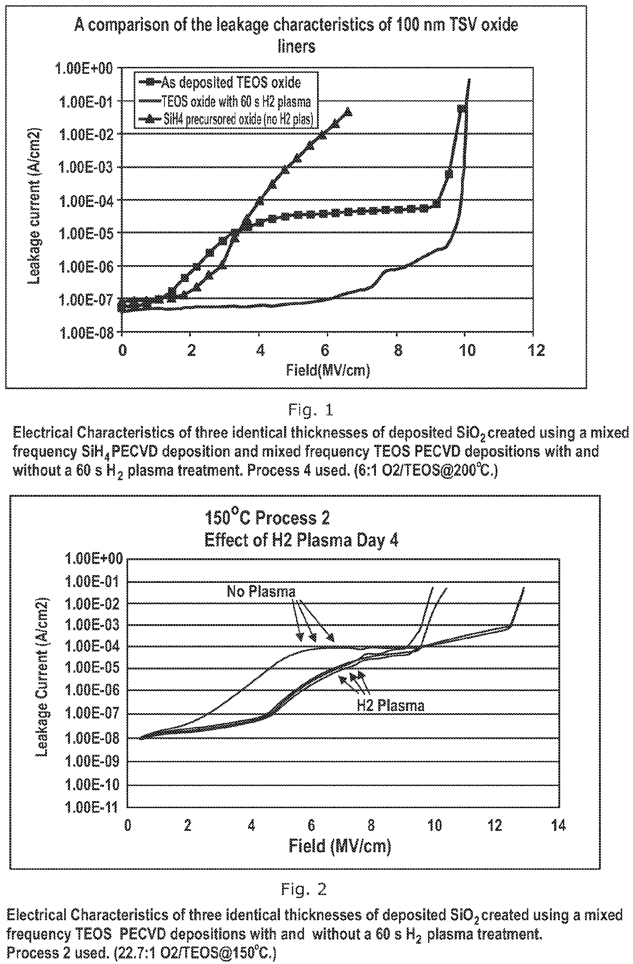

PECVD using TEOS/O₂ precursors have been considered because they have generally good step coverage and the cost of the precursors is relatively low. However, when deposition temperatures are reduced to less than 200°C to 250°C the dielectric properties (leakage and ultimate breakdown) become degraded. In an article entitled Characterisation and Preparation SiO₂ and SiOF films using RF PECVD technique from TEOS₂ and TEOS/O₂/CF₄ Precursors by Kim et al - J. Phys. D: Appl. Phs. 37 (2004) 2425-2431- the authors describe films formed from TEOS/O₂ precursors using different ratios of flow rate for the precursors. It will be noted that in Figure 1 a, of that article, the deposition rate at 200°C falls dramatically and at lower ratios of O₂/TEOS the authors report the incorporation of ethoxy groups into the film. They provide no information about the electrical breakdown characteristics of the films. It will be particularly noted that they report increasing O-H absorption into the film when it is exposed to air after deposition as lower deposition temperatures are used. The invention consists in a method depositing an inorganic, dielectric SiO₂ film that temperatures below 250°C using plasma enhanced chemical vapour deposition (PECVD) in a chamber including supplying tetraethyl orthosilicate (TEOS) and O₂, or a source thereof, as precursors, with an O₂/TEOS ratio of between 15:1 and 25:1; wherein the precursors are deposited using an RF driven showerhead, wherein the showerhead is driven using a high frequency component and a low frequency component; and the high frequency component is at 13.56 MHz and the low frequency component is 350 kHz - 2 MHz. The power supplied at the high frequency component may be approximately twice the power of the low frequency component.

The Applicants have found that surprisingly, the deposited film is inorganic and, specifically, one that includes no methyl groups. This means that they benefit from improved dielectric properties over films containing such groups, whilst benefitting from the conformal properties resulting from the large molecules of the TEOS precursor.

The method may include performing a H₂ plasma treatment on the as deposited film. This treatment may be performed after a vacuum break. It is preferred that the H₂ plasma treatment is sufficient to reform Si-H bonds on the surface of the film.

In any of the above methods, the film may be deposited at temperatures of the range 150°C to 200°C.

A single RF frequency may be used for the H₂ plasma, where the single RF frequency may be 13.56 MHz. The H₂ plasma temperature may be in the range of 125 °C to 200 °C.

The invention may be performed in various ways and specific embodiments will now be described, by way of example, with reference to the accompanying drawings in which:
Figure 1 shows electrical characteristics of three identical thicknesses of deposited SiO₂ created using a mixed frequency SiH₄ PECVD deposition and mixed frequency TEOS PECVD depositions with and without a 60 s H₂ plasma treatment. Process 4 used. (6:1 O₂/TEOS @ 200C.);
Figure 2 shows electrical characteristics of three identical thicknesses of deposited SiO₂, created using a mixed frequency TEOS PECVD depositions with and without a 60 s H₂ plasma treatment. Process 2 used. (22.7:1 O2/TEOS @ 150C.);
Figure 3 shows the electrical leakage with applied field strength for identical TEOS/O₂ deposited films with different lengths of vacuum break before H₂ plasma treatment. Process 4 used (6:1 O2/TEOS @200C);
Figure 4 shows FTIR spectra of TEOS/O₂ film before and after H2 plasma treatment (60,120 and 180sec). Spectra are overlaid as a visual aid. Note the broad peak 3100-3500cm⁻¹ and the flat region 900-1000 cm⁻¹, both due to the presence of O-H bonds in the as deposited film. Process 4 used (6:1 O2/TEOS @ 200C);
Figure 5 shows the electrical leakage with field voltage for various plasma and thermal post deposition treatments of TEOS films. All depositions were performed at 200°C platen. All post deposition treatments were performed insitu except for the 400°C thermal anneal treatment which was performed in a separate module (without a vacuum break);
Figure 6 shows FTIR data from various plasma and thermal post deposition treatments of TEOS films. All depositions were performed at 200°C platen. All post deposition treatments were performed insitu except for the 400°C thermal anneal treatment which was performed in a separate module (without a vacuum break). Spectra are offset for clarity. Note weak peak at 2340cm-1 for H₂ plasma and 400°C H₂ anneal;
Figures 7 shows FTIR spectra of a 150°C TEOS film (6:1 O₂/TEOS) showing OH content increasing with time;
Figure 8a and 8b show variation of a step coverage with temperature for two TEOS processes (with identical hydrogen plasma treatment) Process 1 (15:1 O₂/TEOS) and process 2 (22.7:1 O₂/TEOS). Step coverage improves with higher O₂/TEOS ratio;
Figure 9 shows electrical characteristics of unmodified TEOS process deposited at platen temperatures of 150-250°C (O2/TEOS 6:1) after 24hrs exposure to atmosphere;
Figure 10 shows deposition rates as a function of O2/TEOS ration for 22.7:1 O₂/TEOS process at 175°C. The refractive index (RI) remains between 1.461-1.469 for all conditions;
Figure 11 shows moisture re-absorption as measured by change in 3300cm⁻¹ and 980cm⁻¹ FTIR peaks;
Figure 12 shows leakage is improved by using mixed frequency vs high frequency;

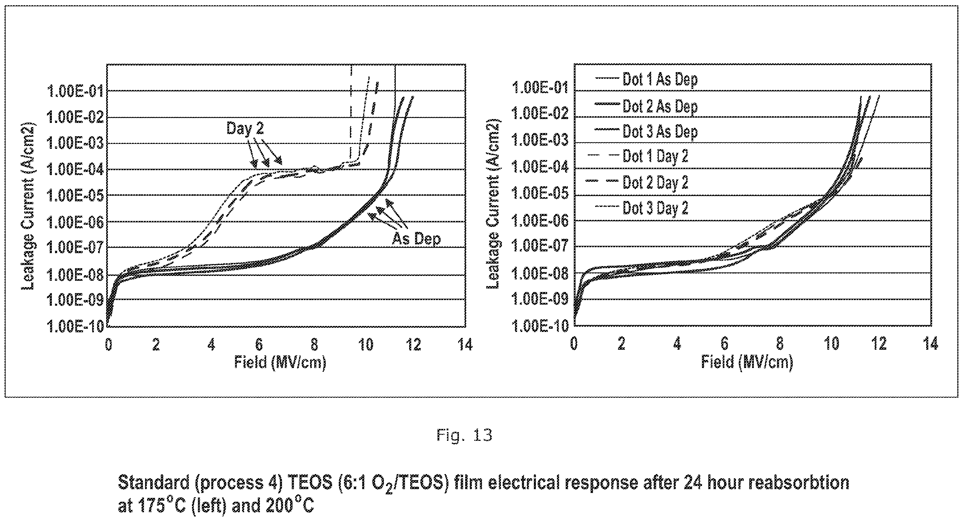

Figure 13 shows standard (process 4) TEOS (6:1 O₂/TEOS) film electrical response after 24 hour reabsorbtion at 175 (left) and 200°C;
Figure 14 shows process 1 TEOS (15:1 O₂/TEOS) film electrical response after 24 hour reabsorbtion at 175°C and 200°C;
Figure 15 shows process 2 TEOS(22.7:1 O₂/TEOS) film electrical response after 24 hour reabsorbtion at 175 (left) and 200°C;
Figure 16 shows process 2 TEOS(22.7:1 O₂/TEOS, 175°C) film FTIR spectra, no change in 980 cm⁻¹ region after 5 days. Indicative of no-moisture absorption.
Figure 17 is a schematic drawing of the apparatus used for deposition.

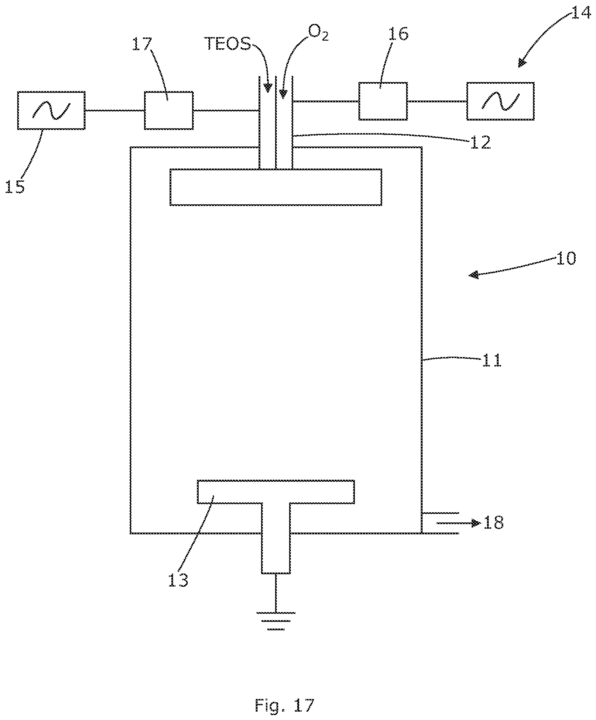

In Figure 17 a schematic apparatus for performing the embodiments of the invention is generally illustrated at 10. It comprises a chamber 11, a showerhead 12, a waversupport 13 and respective high and low frequency sources 14 and 15. The showerhead 12 is arranged to receive two precursors (TEOS and O₂). Matching units 16 and 17 are provided for the high and low frequency sources 14 and 15 respectively and a pumped outlet 18 is provided for removing surplus reaction gases.

Using an apparatus a series of experiments were carried out using the following process conditions:
**Process 1 -** DEP: 320 Pa (2400 mT), 1500 sccm O₂, 1000 sccm He, 1.0 ccm TEOS, 666 W HF, 334 W LF, 14 mm ES (15:1) PLAS: 267 Pa (2000 mT), 1000 sccm H₂, 1000 W HF, 20 mm ES
**Process 2** - DEP: 267 Pa (2000 mT), 1500 sccm O₂, 1000 sccm He, 0.66 ccm TEOS, 666 W HF, 334 W LF, 14 mm ES (22.7:1) PLAS: 2000 mT, 1000 sccm H₂, 1000 W HF, 20 mm ES
**Process** 3 - DEP: 373 Pa (2800 mT), 500 sccm O₂, 1000 sccm He, 1.25 ccm TEOS, 900 W HF, 11 mm ES (4:1)
**Process 4** - DEP: 467 Pa (3500 mT), 750 sccm O₂, 1000 sccm He, 1.25 ccm TEOS, 666 W HF, 334W LF, 14 mm ES (6:1) PLAS: as described or 267 Pa (2000 mT), 1000 sccm H₂, 1000 W HF, 20 mm ES

Where the process pressure is measured in mT, the O₂, TEOS and He carrier gas flows are in sccm, RF power is measured in watts with HF being 13.56MHz and LF at 375kHZ and the electrode (showerhead) to substrate separation ES is in mm
The conditions set out in the above processes are split between an initial deposition process (DEP) and a subsequent plasma treatment (PLAS). The pressure given is the chamber pressure. The helium is used as the process carrier gas. The ratio given in brackets is the ratio off O₂ to TEOS. Figure 1 shows the effect of H₂ plasma treatment on a low temperature 200°C) deposited film. Leakage breakdown is generally regarded as occurring somewhere between 1.00 E-07 and 1.00 E-06 and it would be seen that the hydrogen plasma treated film has significantly improved the breakdown of characteristics.

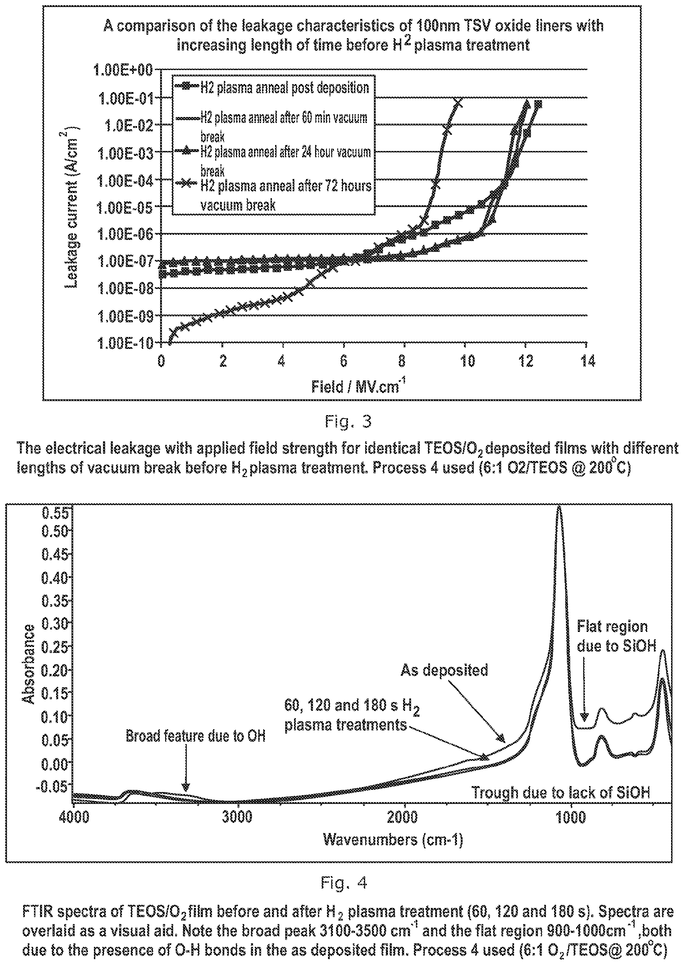

Figure 2 illustrates at the relationship between no plasma treatment and plasma treatment on films deposited at 150°C and it is again seen that the breakdown characteristics are improved. Figure 3 similarly illustrates such characteristics in dependence on when the plasma treatment takes place and it would be seen that it is effective even after quite a lengthy vacuum break but that it seems to be advantageous to have a vacuum break at least up until 24 hours.

Figure 4 shows the FTIR spectra for a number of films having different lengths of the plasma treatment. When compared with the film having no plasma treatment it would be seen that the plasma treatment removes OH peaks at ∼3300 and 980CM⁻¹. There is also a very small peak at 2340CM⁻¹ which indicates the presence of Si-H bonds on more near the surface of the film which would make the film hydrophobic and reduce absorption of water vapour on or through the surface of the film, which has relative little OH in its bulk. It will be noted that there is an absence of any peaks ∼1260cm⁻¹ (Si-CH₃) and ∼3000cm⁻¹ (C-H). This illustrates the inorganic nature of the film.

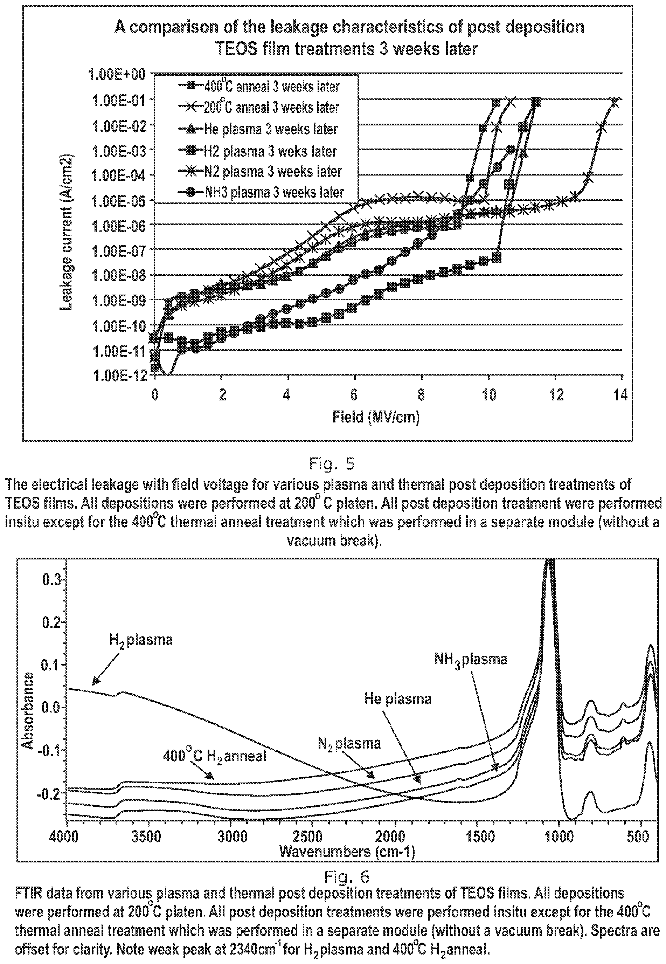

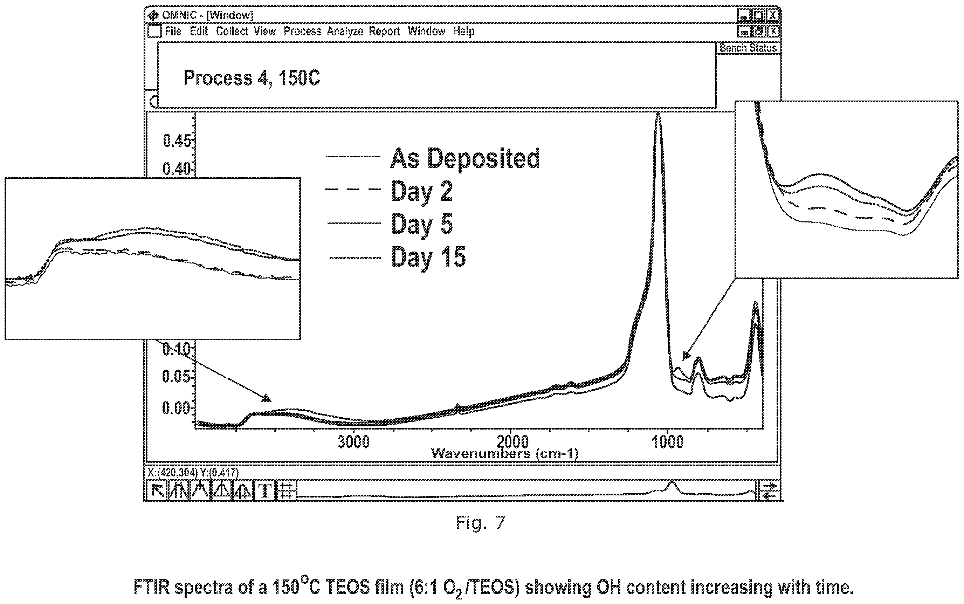

Figures 5 and 6 illustrate the effect of different types of anneals and it would be observed that the H₂ plasma treatment is significantly better than preventing reabsorbtion. Figure 7 looks at the reabsorbtion over time.

Thus from these Figures it can be seen that the H₂ plasma treatment reduces the moisture in the film and reduces the rate of reabsorbtion into the film, probably, at least in part, by creating a hydrophobic surface. The results are excellent even at a deposition temperature of 150°C. It is therefore likely that serviceable films can be obtained below this temperature. The treatment can be carried out after a vacuum break and they possibly be enhanced by such a break.

Preferably the H₂ plasma treatment temperature is low, for example, 200°C or even lower, around 125°C or 150°C.

It is also noted that the use of helium and NH₃ plasma treatments and H₂ furnace anneal do not provide the same results.

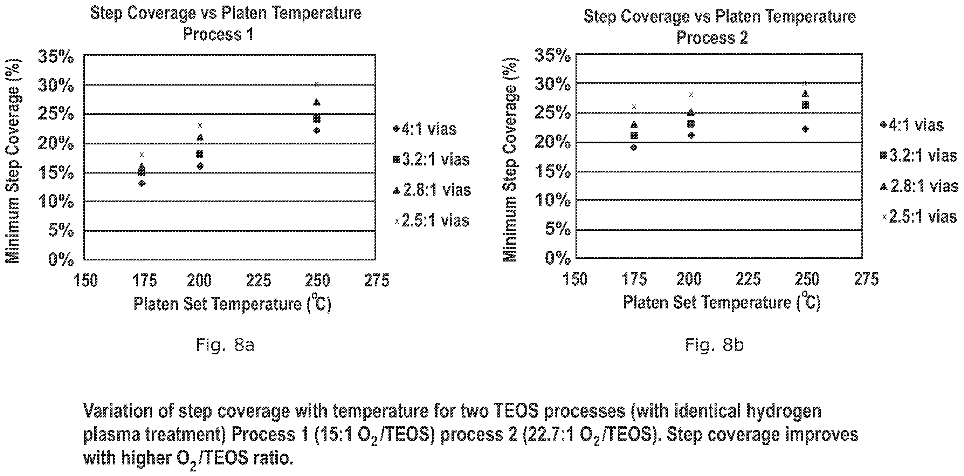

Figures 8a and 8b show the step coverage against the temperature of the support of platen 13. The step coverage improves as temperature is increased and as the O₂/TEOS ratio is increased. However, acceptable step coverage can be achieved at historically low temperatures.

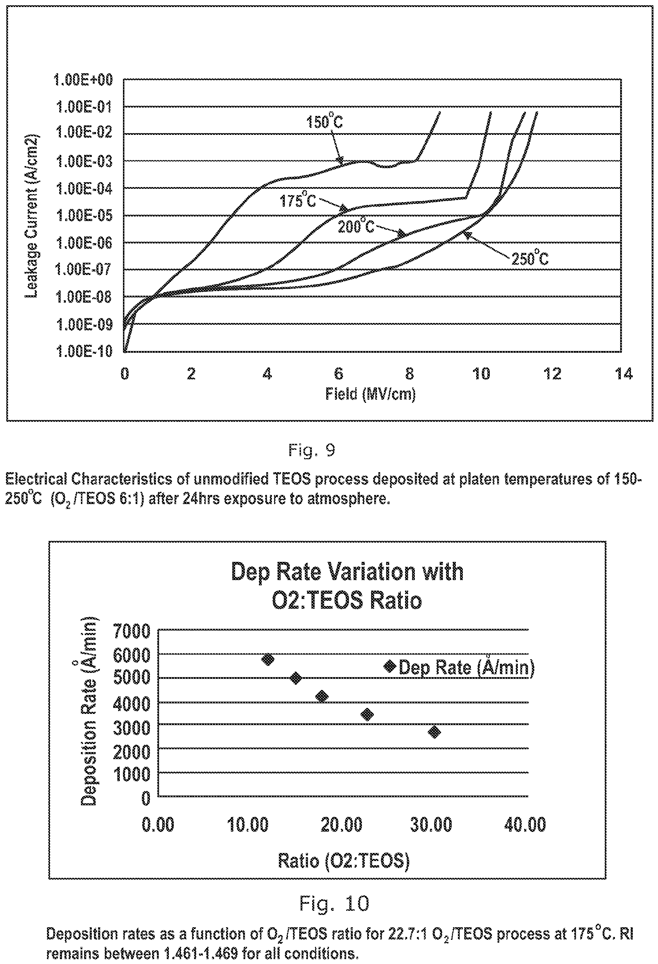

Figure 9 shows the effect of deposition temperature on the leakage current of a plasma treated film and it will be seen that the results are better at high temperature but with the plasma acceptable results can be achieved at quite low temperatures.

Figure 10 illustrates the relationship of deposition rate to 0₂/TEOS ratio and it would be seen that the deposition rate falls as the ratio is increased.

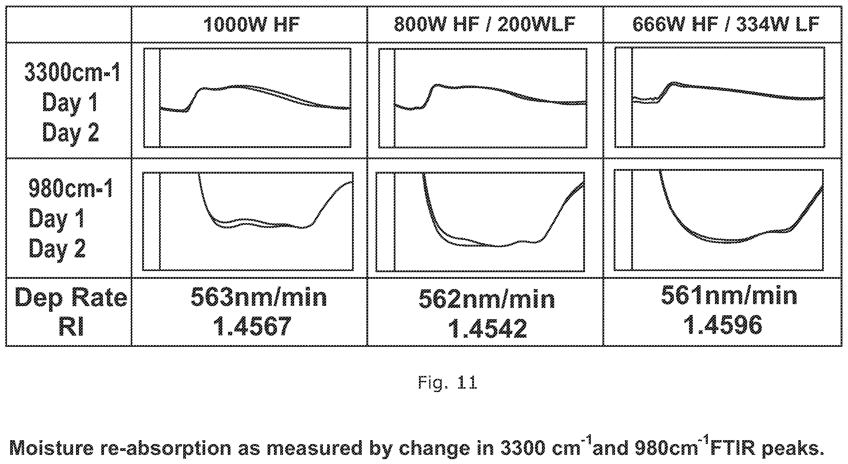

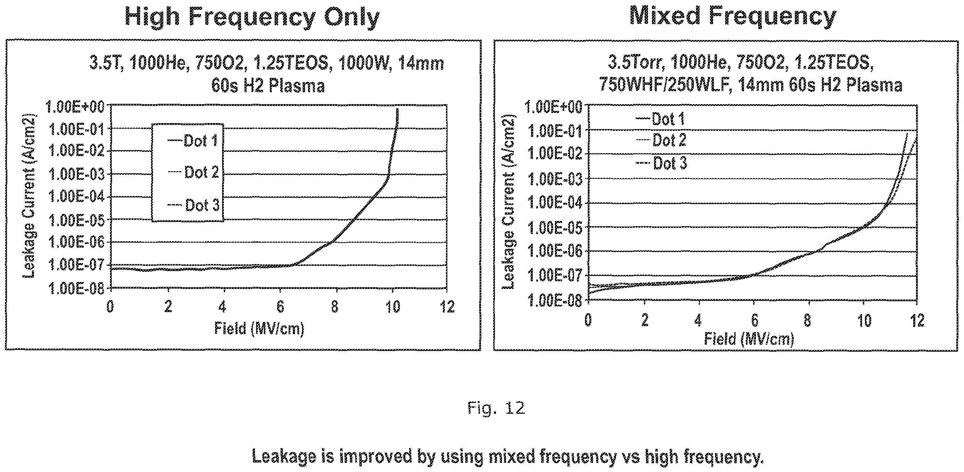

As has been explained above the showerhead is preferably powered at mixed frequencies and a typical arrangement is a high frequency of 13.56MHz and a low frequency of 375kHz. It is however believed that the low frequency component could be increased in frequency at least up until 2MHz. It has been determined that the introduction of the low frequency component does not change the deposition rate and therefore is not believed to be increasing the density of the film by ion bombardment. Figure 11 shows the effect of introducing the low frequency component on reabsorbtion. The deposition conditions for this experiment were as set out in process 4 subject to the variation in the RF components indicated in the figure. There is visibly less reabsorbtion when mixed frequency is used as opposed to a single 13.56MHz RF source. With no significant changes in deposition rate or refractive index of the SiO₂ film it is likely that the LF component is changing the gas species in the plasma. Figure 12 compares the difference in leakage current between high frequency only and mixed frequency. The references to dot1, dot2, and dot3 indicate measurements at different points on the waver. It will be seen that there is a significant improvement in the leakage characteristics. In general it can be concluded that the presence of the low frequency power provides less OH reabsorbtion and a higher breakdown voltage.

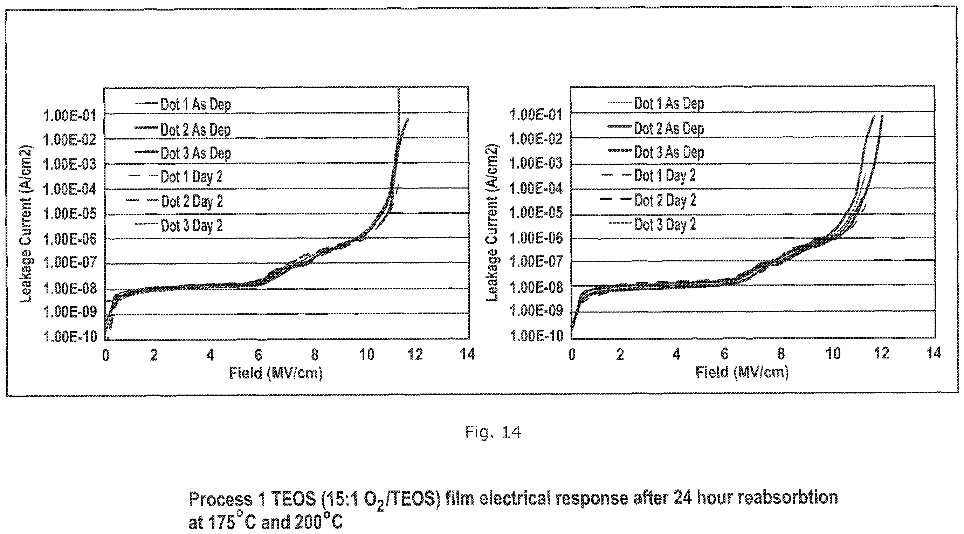

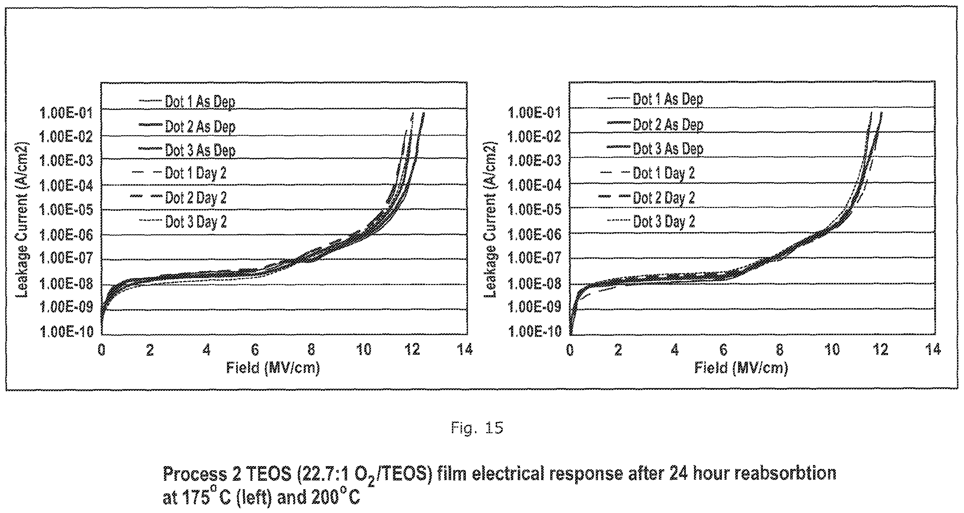

Figures 14 to 16 effectively compare the electrical response after 24 hours reabsorbtion at 175°C and 200°C for different O₂/TEOS ratios. It would be seen that at the low ratio of 6:1 there is significant reabsorbtion at 175°C but the extent of the deterioration and performance decreases when the ratio is increased.

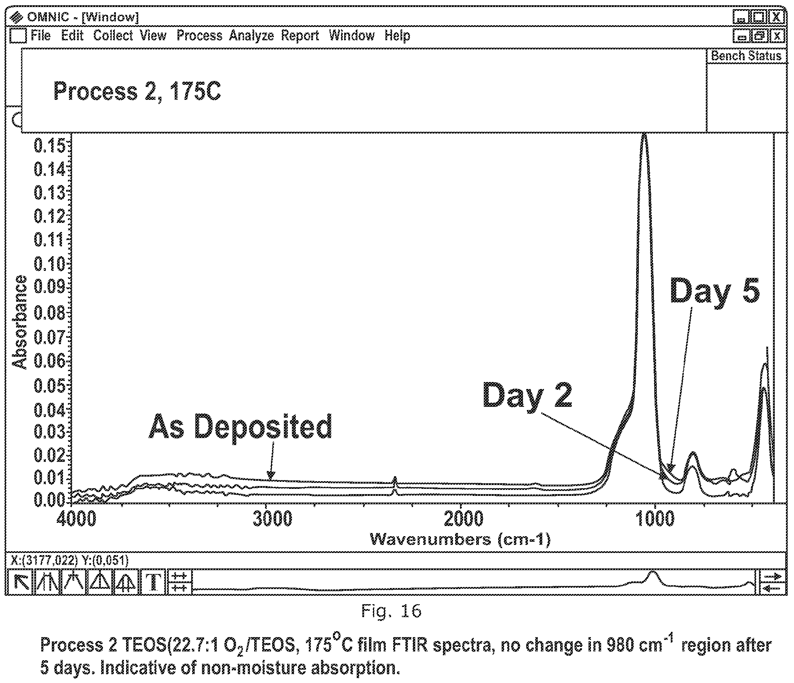

Figure 16 illustrates the good absorbtion performance of a process 2 film.

From the above it can be seen that a film deposited at temperatures below 200°C with good leakage characteristics and good step coverage can be achieved at a relatively high O₂/TEOS ratio such as a round 22:1 utilising mixed frequency RF power and ideally an H₂ plasma treatment step. However the data also shows that improved films can be achieved using a selection of these criteria.

It is envisaged that films may be deposited at temperatures as low as 125°C.

## Claims

1. A method of depositing an inorganic, dielectric SiO₂ film at temperatures below 250°C using plasma enhanced chemical vapour deposition (PECVD) in a chamber including supplying tetraethyl orthosilicate (TEOS) and O₂/TEOS ratio of between 15:1 and 25:1;
wherein the precursors are deposited using an RF driven showerhead, wherein the showerhead is driven using a high frequency component and a low frequency component; and
the high frequency component is at 13.56 MHz and the low frequency component is 350kHz - 2MHz.

2. A method as claimed in claim 1 wherein the power supplied at the high frequency is approximately twice the power of the low frequency component.

3. A method as claimed in claim 1 or 2 further including performing an H₂ plasma treatment on the as deposited film.

4. A method as claimed in claim 3 wherein the H₂ plasma treatment is performed after a vacuum break.

5. A method as claimed in claim 3 or claim 4 wherein the H₂ plasma treatment forms or reforms Si-H bonds on the surface of the film.

6. A method as claimed in any one of the preceding claims wherein the film deposited at temperatures in the range 150°C - 200°C.

7. A method as claimed in claim 3 or any one of claims 4 to 6 as dependent on claim 3 wherein a single RF frequency is used for the H₂ plasma.

8. A method as claimed in claim 7 wherein the single RF frequency is 13.56 MHz.

9. A method as claimed in claim 3 or any one of claims 4 to 8 as dependent on claim 3 wherein the H₂ plasma temperature is in the range 125°C to 200°C.

## Patentansprüche

1. Verfahren zum Abscheiden eines anorganischen, dielektrischen SiO₂-Films bei Temperaturen unter 250 °C unter Verwendung einer plasmaunterstützten chemischen Gasphasenabscheidung (PECVD) in einer Kammer, umfassend das Zuführen von Tetraethylorthosilikat (TEOS), und einem O₂/TEOS-Verhältnis zwischen 15:1 und 25:1;
wobei die Vorstufen unter Verwendung eines Radiofrequenz-betriebenen Sprühkopfs abgeschieden werden, wobei der Sprühkopf unter Verwendung einer Hochfrequenzkomponente und einer Niederfrequenzkomponente betrieben wird; und
die Hochfrequenzkomponente bei 13,56 MHz liegt und die Niederfrequenzkomponente bei 350 kHz bis 2 MHz liegt.

2. Verfahren nach Anspruch 1, bei dem die Leistung, die bei der Hochfrequenz zugeführt wird, etwa das Doppelte der Leistung der Niederfrequenzkomponente beträgt.

3. Verfahren nach Anspruch 1 oder 2, das ferner das Durchführen einer H₂-Plasmabehandlung mit dem abgeschiedenen Film umfasst.

4. Verfahren nach Anspruch 3, bei dem die H₂-Plasmabehandlung nach einer Vakuumunterbrechung durchgeführt wird.

5. Verfahren nach Anspruch 3 oder Anspruch 4, bei dem die H₂-Plasmabehandlung Si-H-Bindungen auf der Oberfläche des Films bildet oder umbildet.

6. Verfahren nach einem der vorhergehenden Ansprüche, bei dem der Film bei Temperaturen im Bereich von 150 °C bis 200 °C abgeschieden wird.

7. Verfahren nach Anspruch 3 oder einem der Ansprüche 4 bis 6, soweit diese von Anspruch 3 abhängen, bei dem für das H₂-Plasma eine einzelne Radiofrequenz verwendet wird.

8. Verfahren nach Anspruch 7, bei dem die einzelne Radiofrequenz 13,56 MHz beträgt.

9. Verfahren nach Anspruch 3 oder einem der Ansprüche 4 bis 8, soweit diese von Anspruch 3 abhängen, bei dem die H₂-Plasma-Temperatur im Bereich von 125 °C bis 200 °C liegt.

## Revendications

1. Procédé de dépôt d'un film de SiO₂ diélectrique, inorganique, à des températures au-dessous de 250°C à l'aide d'un dépôt chimique en phase vapeur assisté par plasma (PECVD) dans une chambre comprenant l'introduction d'orthosilicate de tétraéthyle (TEOS) et d'un rapport O₂/TEOS d'entre 15:1 et 25:1 ;
dans lequel les précurseurs sont déposés à l'aide d'une pomme d'arrosage commandée par RF, la pomme d'arrosage étant commandée à l'aide d'un composant haute fréquence et d'un composant basse fréquence ; et
le composant haute fréquence est à 13,56 MHz et le composant basse fréquence est 350 KHz-2 MHz.

2. Procédé selon la revendication 1, dans lequel la puissance fournie à la haute fréquence est approximativement de deux fois la puissance du composant basse fréquence.

3. Procédé selon l'une des revendications 1 ou 2, comprenant en outre la réalisation d'un traitement par plasma de H₂ sur le film tel que déposé.

4. Procédé selon la revendication 3, dans lequel le traitement par plasma de H₂ est effectué après un cassage de vide.

5. Procédé selon la revendication 3 ou la revendication 4, dans lequel le traitement par plasma de H₂ forme ou reforme des liaisons Si-H sur la surface du film.

6. Procédé selon l'une quelconque des revendications précédentes, dans lequel le film est déposé à des températures se situant dans la plage de 150°C-200°C.

7. Procédé selon la revendication 3 ou selon l'une quelconque des revendications 4 à 6 en tant que dépendante de la revendication 3, dans lequel une simple fréquence RF est utilisée pour le plasma de H₂.

8. Procédé selon la revendication 7, dans lequel la simple fréquence RF est 13,56 MHz.

9. Procédé selon la revendication 3 ou selon l'une quelconque des revendications 4 à 8 en tant que dépendante de la revendication 3, dans lequel la température de plasma de H₂ se situe dans la plage de 125°C à 200°C.
